# EUROPEAN PATENT APPLICATION

(11) **EP 1 437 764 A1**
(43) Date of publication of application: **14.07.2004**
(21) Application number: 03290072.2
(22) Date of filing: 10.01.2003
(51) Int. Cl.: H01L 21/20, H01L 21/762

(54) **A compliant substrate for a heteroepitaxy, a heteroepitaxial structure and a method for fabricating a compliant substrate**

(71) Applicant: S.O.I. Tec Silicon on Insulator Technologies S.A., 38190 Bernin (FR)
(72) Inventor: Akatsu, Takeshi, 38330 Saint Nazaire Les Eymes (FR)
(74) Representative: Grünecker, Kinkeldey, Stockmair & Schwanhäusser Anwaltssozietät

(57) **Abstract**

The present invention relates to a compliant substrate for a heteroepitaxy, a heteroepitaxial structure and a method for fabricating a compliant substrate for a heteroepitaxy. It is the object of the present invention to provide a compliant substrate, a heteroepitaxial structure and a method for fabricating a compliant substrate allowing a heteroepitaxial layer to be brought onto a compliant substrate with a very low defect rate and a high rate of reproduction and efficiency. The object is solved by a compliant substrate for a heteroepitaxy, a heteroepitaxial structure and a method for fabricating a compliant substrate for a heteroepitaxy, wherein the compliant substrate comprises a carrier substrate; a buried layer; and a single-crystalline top layer; wherein the buried layer is between the carrier substrate and the top layer, and a region in the top layer and/or a region at or near an interface between the buried layer and the top layer is weakened.

## Description

The present invention relates to a compliant substrate for a heteroepitaxy, a heteroepitaxial structure and a method for fabricating a compliant substrate for a heteroepitaxy.

A compliant substrate is a type of a substrate which has been engineered in such a way as to accommodate the strain that results from heteroepitaxial growth of a material with a lattice parameter different from the substrate.

WO 99/39377 describes a compliant substrate consisting of a silicon wafer having in a very small depth of the wafer a layer of microcavities being generated by a hydrogen ion implantation into the silicon wafer. The thin silicon layer formed above the implanted region acts as a compliant layer on which a heteroepitaxial layer can be deposited.

WO 99/39377 further mentions a prior art technology using a SOI (silicon-on-insulator) structure to provide a compliance effect for a heteroepitaxy on top of the SOI structure. It is explained that it is not recommended to use SOI structures as compliant substrates since several further process steps such as thermal treatments at higher temperatures and/or boron or phosphor implantations of the SiO₂ layer of the SOI-substrate are necessary to achieve sufficient compliance of the SOI-substrate. In particular, the thermal treatments are frequently incompatible with the epitaxial layer so that a sufficient compliance cannot be provided.

Both of the above approaches are not able to provide a compliance which is sufficient enough for producing a low stress and high quality heteroepitaxial layer on the respective substrates.

It is therefore the object of the present invention to provide a compliant substrate, a heteroepitaxial structure and a method for providing a compliant substrate, allowing a heteroepitaxial layer to be brought onto a compliant substrate with a very low defect rate and a high rate of reproduction and efficiency.

The object is solved by a compliant substrate for a heteroepitaxy, comprising: a carrier substrate; a buried layer; and a single-crystalline top layer; wherein the buried layer is between the carrier substrate and the top layer, and a region in the top layer and/or a region at or near an interface between the buried layer and the top layer is weakened.

The inventive substrate provides with the weakened region at or near said interface a very good slippage between the top layer and the buried layer and good isolation from the carrier substrate due to the buried layer therebetween. This allows a low stress growth of an epitaxial layer on the compliant substrate with a high efficiency. The inventive substrate makes it possible for a heteroepitaxial structure with a relatively thick but relaxed heteroepitaxial layer on top of the top layer to be produced.

In contrast to the prior art, the compliant substrate of the present invention provides a new quality of stress adaptation. In particular, it turned out that the region at or near the interface between the buried layer and the top layer can be weakened exceedingly so that this weakened layer can provide a very high compliance effect.

This effect will further be achieved or be improved by the weakening of a region in the top layer. That weakened region can be provided in an immediate vicinity of the top of the compliant substrate, which makes it possible to have a better effect on the quality of a heteroepitaxial layer on top of the compliant substrate. When the weakened region in the top layer acts in addition with a weakened region at or near the interface, a nearly perfect growth of a heteroepitaxial layer on the compliant substrate can be attained.

According to an example of the invention, the weakened region contains implanted species. These species can provide, in a simple way, damages or microcavities in that region which allow a good slippage characteristic between the buried layer and the top layer. The species can especially well be gettered in the region at or near the interface so that this species containing region can be provided with a very low thickness, resulting in an improved compliance effect between the compliant substrate and a heteroepitaxial layer on top of this substrate.

In a favourable embodiment of the invention the implanted species are selected from a group comprising hydrogen or rare gas. Rare gases are elements of the eighth main group of the periodic table of the elements and comprise, e.g., helium. These species can be implanted with a high efficiency and accuracy leading to a pre-determinable depth and quantity of damages at or near the interface between the buried layer and the top layer and/or in the top layer.

According to a preferred embodiment of the invention, the buried layer is an amorphous and/or a porous layer, which decreases an adhesion force between the buried layer and the top layer, resulting in an enhanced slippage effect therebetween.

As a variant of the invention, the buried layer comprises silicon dioxide. This material can be provided efficiently on the carrier substrate and as further a good isolation characteristic, for instance with reference to a top layer comprising silicon.

Optionally, the top layer has a thickness of less than about 20 nm. This thin layer is particularly suitable for relaxed growth of a heteroepitaxial layer on top of the top layer.

The object of the invention is further solved by a heteroepitaxial structure comprising: the compliant substrate of at least one of the claims 1 to 6; and a second single-crystalline epitaxial layer on top of the top layer, wherein a lattice constant of the second layer is different from a lattice constant of the top layer and/or a region in the top layer.

This heteroepitaxial structure offers a homogeneous, low stress epitaxial layer on top of the top layer, wherein the heteroepitaxial layer can be provided with a relatively high thickness in relation to the top layer. The weakened region between the third layer and the top layer, allows good slippage at the interface between the buried layer and the top layer, causing a nearly defect-free growth of the second epitaxial layer. This results in a heteroepitaxial structure with very good electronic characteristics which can be produced in a relatively simple but efficient way.

The object of the invention is further solved by a method for fabricating a compliant substrate for heteroepitaxy, comprising: fabricating a base structure having a buried layer between a carrier substrate and a single-crystalline top layer; and weakening a region in the top layer and/or a region at or near an interface between the buried layer and the top layer.

With the inventive method, a compliant substrate can be produced which can provide good slippage at or near the interface between the buried layer and the top layer and/or at the weakened region in the top layer, resulting in low stress growth of a heteroepitaxial layer on top of the top layer. The method has the advantage that a simple structure comprising a carrier substrate, a buried layer and a single-crystalline top layer can be used, followed by an easy weakening step, resulting in a high productivity of fabricating high quality compliant substrates for heteroepitaxial applications.

According to a special embodiment, weakening comprises implanting species in the region at or near the interface between the buried layer and the top layer and/or in the region in the top layer. In this way, that or these region(s) can be weakened very precisely with high efficiency. Specifically, microcavities can be generated in a pre-definable manner by this step, causing a particularly good weakening effect. As a very good effect of this method, especially the species which are implanted in the region near the interface between the buried layer and the top layer will be gettered in a relatively thin region at or near this interface resulting in an improved compliance of the fabricated compliant substrate.

In a further favourable example of the invention, an energy and/or a depth of the species implanted in the implanting step is adjusted so that a maximum concentration of the implanted species is approximately at or near the interface between the buried layer and the top layer. By this method, in particular the interface between the buried layer and the top layer can be weakened, resulting in an enhanced slippage effect between the buried layer and the top layer.

In a special embodiment of the invention, a dose of the implanted species is about 3 x 10¹⁶cm⁻². This dose provides for a good weakening effect but prevents blistering of the implanted structure.

As a variant of the invention, implanting is done through a thick top layer and the method further comprises a thinning of the top layer. Through the thick top layer, implanting can be targeted in a defined region so that particularly the interface between the buried layer and the top layer can be provided with the species in the implanting step. The thinning step which can be carried out after the implanting step results in a thinned top layer which can better slip on the buried layer, resulting in better absorption of a lattice mismatch between the top layer and the heteroepitaxial layer.

Advantageously, thinning comprises an oxidation and/or an etching of the top layer. Through this method, the thickness of the top layer can be decreased with a low influence on the weakened region at or near the interface between the buried layer and the top layer.

Preferably, at least one auxiliary layer is provided on the top layer prior to the weakening step. This makes it possible to achieve a precise weakening of the region at or near the interface between the buried layer and the top layer even when the top layer has a low thickness. The auxiliary layer has the advantage that it can be so chosen that it can be easily removed from the top layer.

In accordance with a special embodiment of the invention, the step of the providing the auxiliary layer comprises depositing a silicon dioxide layer. The silicon dioxide layer can be easily brought onto the top layer and can be easily removed. Through this layer, in particular, an implanting step can be easily made, so that precise weakening of the region at or near the interface between the buried layer and the top layer can be provided.

This step of fabricating the base structure may possibly comprise fabricating a silicon-on-insulator structure. These structures comprise an interface between the silicon and the insulator layer which can be easily weakened, for instance by an implantation step, so that, based on the silicon-on-insulator structure, a compliant substrate can be fabricated in a very efficient way.

In an advantageous example of the present invention, the method further comprises providing a second single-crystalline epitaxial layer on the top layer, wherein a lattice constant of the deposited second layer is different from a lattice constant of the top layer resulting in a heteroepitaxial structure. This heteroepitaxial structure can be fabricated with a nearly defect-free second epitaxial layer on top of the top layer, wherein the second layer can be produced with a relatively high thickness in a way that is efficient and easily reproduced.

It is further advantageous to provide a second single-crystalline epitaxial layer on the top layer after the weakening of the region at or near the interface between the buried layer and the top layer and/or the region in the top layer. Using this process sequence, the second single-crystalline epitaxial layer can be provided nearly defect-free resulting in a high quality heteroepitaxial structure.

In a further embodiment of the invention, the method further comprises an annealing step of the heteroepitaxial structure. This allows a good relaxation of the second crystalline epitaxial layer on top of the compliant substrate.

Favourable embodiments of the invention are illustrated in the figures of the drawing and will hereinafter be explained wherein:
- Fig. 1: shows schematically a side view of a compliant substrate according to an embodiment of the invention;
- Fig. 2: shows schematically a side view of a heteroepitaxial structure according to an embodiment of the invention;
- Figs. 3 to 5: show schematically an exemplary process flow of a first embodiment of the inventive method for fabricating a compliant substrate as shown in Fig. 1;
- Figs. 6 to 8: show schematically an exemplary process flow of a second embodiment of the inventive method for fabricating a compliant substrate as shown in Fig. 1; and
- Fig. 9: shows schematically a growth and an annealing of a second heteroepitaxial layer on a compliant substrate, resulting in a heteroepitaxial structure as shown in Fig. 2.

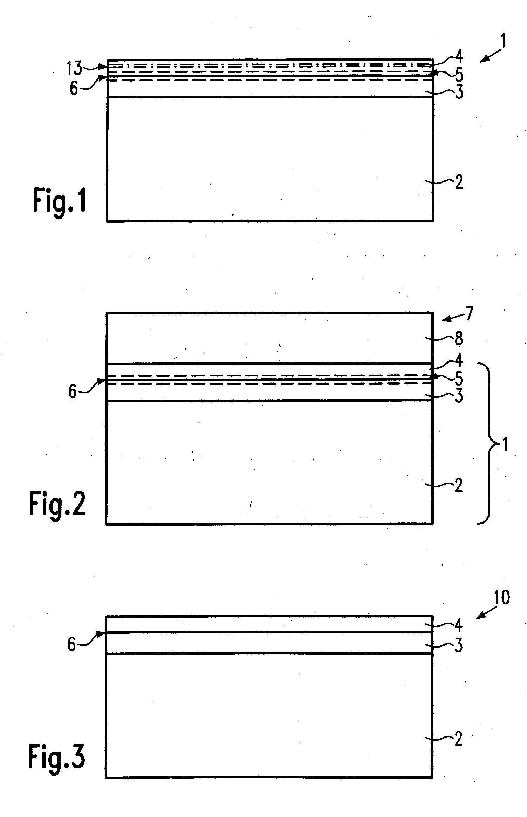

Fig. 1 shows schematically a side view of a compliant substrate 1 according to an embodiment of the invention. The compliant substrate 1 comprises a carrier substrate 2 which is, for instance, of silicon and has a thickness of several micrometers to several hundred micrometers. Instead of silicon, any other material known in the art can be used as carrier substrate materials.

This carrier substrate 2 is covered by a buried layer 3. Preferably, the buried layer 3 is an amorphous and/or a porous layer, such as an insulator layer. In the embodiment shown, the buried layer 3 consists of silicon dioxide and has a thickness of about several tens of nanometres to several hundred nanometres. In further not-shown embodiments of the present invention, the buried layer 3 can comprise Si₃N₄, Al₂O₃, HFO₂ or SrTiO₃ or a combination of at least two of these materials, in addition to or instead of SiO₂.

On the buried layer 3 lies a single-crystalline top layer 4. In Fig. 1, the single-crystalline top layer 4 is a thin silicon layer. In other not-shown examples of the present invention, the top layer 4 can comprise another material such as GeSi, sapphire or an A_{III}B_{V}-material like GaAs, InP or GaN or a combination of at least two of these materials, in addition to or instead of silicon. Preferably, the silicon layer 4 is an ultra-thin layer with a thickness of about several tens of nanometres or less. With reference to Fig. 1, the thickness of the silicon layer 4 is less than 20 nm. Instead of silicon, any other material which is different from the material of the buried layer 3 can be used as single-crystalline top layer 4.

Between the top layer 4 and the buried layer 3 is an interface 6. In a region 5 at or near the interface 6, the material is weakened. As shown with a region 13 between the dotted-dashed lines in Fig. 1, in addition or instead of region 5, the region 13 can be weakened by implanting species in that region.

In the embodiment shown, the weakened region 5 contains preferably a layer of damages or microcavities generated by implanted species (not shown) which are included in that region 5. The implanted species can be of hydrogen or of a rare gas such as helium.

Although not explicitly shown, the regions 5 and/or 13 can be weakened with any available kind of method which is suited to affect the stability of that or these region(s).

The top layer 4 can slip or slide on the buried layer 3 due to the different material characteristics of the top layer 4 and the buried layer 4 and additionally due to the weakened region 5 which enhances the slippage effect between the top layer 4 and the buried layer 3.

Fig. 2 shows schematically a side view of a heteroepitaxial structure 7, according to an embodiment of the invention. The heteroepitaxial structure 7 contains a compliant substrate 1 such as the compliant substrate 1 of Fig. 1. As mentioned in detail with reference to Fig. 1, the compliant substrate 1 comprises a carrier substrate 2, a buried layer 3 and a single-crystalline top layer 4, with a weakened region 5 between the top layer 4 and the buried layer 3 at or near an interface 6 between the buried layer 3 and the top layer 4. The features of these layers or regions are the same as explained with reference to Fig. 1.

In Fig. 2, a second single-crystalline epitaxial layer 8 is on top of the top layer 4. The second single-crystalline epitaxial layer 8 has a lattice constant which is different from the lattice constant of the top layer 4. For example, the second layer 8 can be a GeSi layer, such as a GeSi layer with a germanium concentration between about 20 and 60%, or an A_{III}-B_{V}-semiconductor layer such as GaAs, InP or GaN. The thickness of the second layer 8 can be of several hundred nanometres.

Figs. 3 to 5 show schematically an exemplary process flow of an inventive method according to a first embodiment of the inventive method. In accordance with a first step shown in Fig. 3, a silicon-on-insulator structure 10 or SOI-structure is fabricated. The silicon-on-insulator structure 10 can be fabricated for example by SIMOX or by Smart Cut® technology, resulting in a structure consisting of a carrier substrate 2, for instance of silicon, which is covered by a buried layer 3 of silicon dioxide and having on top a single-crystalline top layer 4 of silicon. As shown in Fig. 1, the top layer 4 and the buried layer 3 form an interface 6 therebetween.

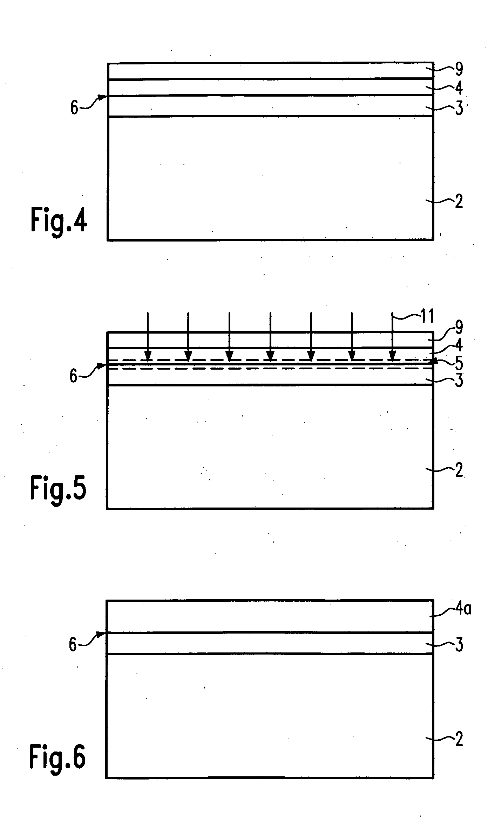

Fig. 4 shows the silicon-on-insulator structure of Fig. 3 after a further step in which an auxiliary layer 9 such as a silicon dioxide layer is deposited on the top layer 4. Any other material known in the art which can easily be deposited and then removed from the top layer 4 can be used Instead of silicon dioxide as auxiliary layer 9.

Fig. 5 shows the structure of Fig. 4 during a further step of the inventive method in which species 11, such as accelerated hydrogen ions, are implanted through the auxiliary layer 9 and the top layer 4 into a region 5 which is at or near the interface 6 between the top layer 4 and the buried layer 3. The species 11 which can form a layer of damages or microcavities in said region 5, causing a weakening of that region 5.

In this step, the implantation energy and/or the implantation depth may be so adjusted that a maximum or a peak of the implanted species is at or near an interface between the top layer 4 and the buried layer 3.

The implantation dose is preferably in a region of about 3 x 10¹⁶ H⁺-atoms/cm² or less so that blistering does not occur on the implanted surface, for instance, during later thermal treatments.

The implantation can be coupled with a thermal treatment of the implanted structure, for instance at temperatures between about 300°C and about 1100°C for approximately 1 hour.

Figs. 6 to 8 show schematically an exemplary process flow of a second embodiment of the inventive method.

Fig. 6 shows schematically a side view of a silicon-on-insulator structure 10a, which has been fabricated in a first step. The silicon-on-insulator structure may be fabricated, for instance, by SIMOX or by Smart Cut® technology, resulting in a structure consisting of carrier substrate 2 such as a silicon substrate covered by a buried layer 3 of silicon dioxide having on top a thick single-crystalline top layer 4a of silicon with a thickness of about 500nm. Preferably, the thick single-crystalline top layer 4 has a thickness of about several hundred nanometres. Between the top layer 4a and the buried layer 3 an interface 6 is formed.

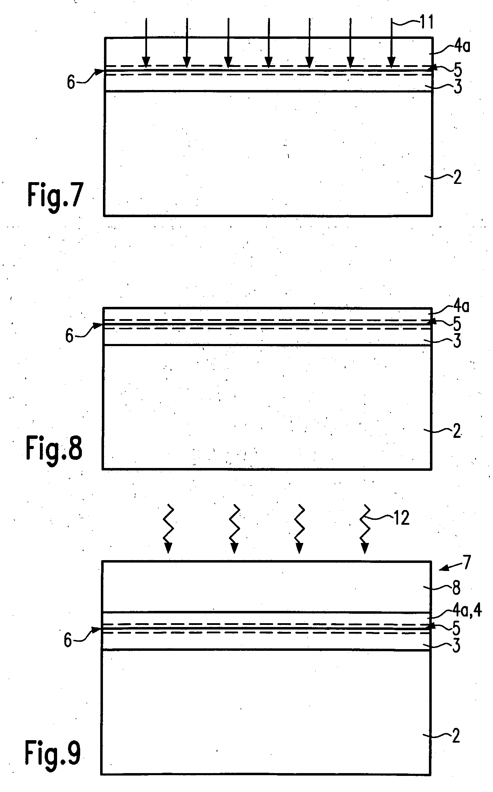

Fig. 7 shows the silicon-on-insulator structure 10a of Fig. 6 during an implantation step in which species 11 are implanted through the thick top layer 4a into a relatively thin region 5 at or near the interface 6 between the thick top layer 4a and the buried layer 3. The implanted species 11 are, for example, hydrogen ions which are accelerated with an energy of about 40 keVand which have a dose of about 3 x 10¹⁶ H⁺/cm². The implanted species 11 concentrate in said thin regions and cause the generation of damages or microcavities in said region 5, resulting in a weakening of the material in that region 5.

The region 5 and in particular the interface 6 between the top layer 4a and the buried layer 3 is used to getter the implanted species 11. Therefore, a damaged implanted area is concentrated over the thin thickness of region 5 which improves compliance of the resulting compliant substrate.

Fig. 8 shows the structure of Fig. 7 after a thinning step in which the thick top layer 4a is thinned down to several tens of nanometres. For example, the thick top layer 4a of Fig. 7 can be oxidised and the oxidised part of the thick top layer 4a can be removed in an etching step during the thinning step. In another variant of the invention, the thick top layer 4a can be thinned down by using chemical-mechanical polishing or a combination of an abrasive method and an etching method.

With reference to Fig. 9, the structures shown in Fig. 5 or in Fig. 8, a second single-crystalline epitaxial layer 8 is grown, resulting in a heteroepitaxial structure 7 such as the structure 7 of Fig. 2. The material of the second layer 8 has a lattice constant which is different from the lattice constant of the top layer 4, 4a. For instance, the second layer , such as a GeSi layer with a Ge concentration of about 20 to 60%, can be a GeSi layer or an A_{III}-B_{V}-semiconductor. Because of the enhanced slippage effect between the top layer 4, 4a and the buried layer 3 at the interface 6 between these layers, the second layer 8 can be grown epitaxially on the top layer 4, 4a, with a low stress, resulting in a nearly defect-free growth of the second epitaxial layer 8 on the top layer 4, 4a. In this way, the second layer 8 can be grown with high quality up to a thickness of several hundred nanometres.

As shown by the arrows 12 in Fig. 9, the heteroepitaxial structure 7 is thermally treated after the growth of the second single-crystalline layer 8, resulting in a very good relaxation of the second layer 8.

In the above example, the second epitaxial layer 8 is grown on the compliant substrate 1 after implantation of the region 5 and/or region 13. In a further embodiment of the invention, the growth or deposition of the second epitaxial layer 8 can be carried out on a non-implanted substrate such as on the structure 10 shown in Fig. 3 followed by an implantation step through the second epitaxial layer 8 into the top layer 4 and/or the region 5 at or near the interface 6. In this case, the implantation can be made through the complete thickness of the second layer 8 or can be carried out as an intermediate step during the growth or between several growth steps of the second layer 8.

Preferably, the respective structure is annealed after an implantation step.

## Claims

1. A compliant substrate (1) for a heteroepitaxy, comprising:
a carrier substrate (2);
a buried layer (3); and
a single-crystalline top layer (4);
wherein the buried layer (3) is between the carrier substrate (2) and the top layer (4), and a region (13) in the top layer (4) and/or a region (5) at or near an interface (6) between the buried layer (3) and the top layer (4) is weakened.

2. The substrate of claim 1, **characterised in that** the weakened region contains implanted species (11).

3. The substrate of claim 2, **characterised in that** the implanted species (11) are selected from a group comprising hydrogen or rare gas.

4. The substrate of at least one of the preceding claims, **characterised in that** the buried layer (3) is an amorphous and/or a porous layer.

5. The substrate of at least one of the preceding claims, **characterised in that** the buried layer (3) comprises silicon dioxide.

6. The substrate of at least one of the preceding claims **characterised in that** the top layer (4) has a thickness of less than about 20 nm.

7. A heteroepitaxial structure (7) comprising:
the compliant substrate (1) of at least one of the preceding claims; and
a second single-crystalline epitaxial layer (8) on top of the top layer (4);
wherein a lattice constant of the second layer (8) is different from a lattice constant of the top layer (4).

8. A method for fabricating a compliant substrate (1) for a heteroepitaxy, comprising:
fabricating a base structure having a buried layer (3) between a carrier substrate (2) and a single-crystalline top layer (4); and
weakening a region (13) in the top layer (4) and/or a region (5) at or near an interface (6) between the buried layer (3) and the top layer (4).

9. The method of claim 8, **characterised in that** weakening comprises implanting species (11) in said region (5) and/or said region (13).

10. The method of claim 9, **characterised in that** an energy and/or a depth of the species implanted in the implanting step is so adjusted that a maximum concentrate of the implanted species (11) is approximately at or near the interface (6) between the buried layer (3) and the top layer (4).

11. The method of at least one of claims 9 to 10, **characterised in that** a dose of the implanted species (11) is about 3 x 10¹⁶cm⁻².

12. The method of at least one of claims 9 to 12, **characterised in that** implanting is made through a thick top layer (4a) and the method further comprises a thinning of the top layer (4a).

13. The method of claim 12, **characterised in that** thinning comprises an oxidation and/or an etching of the top layer (4).

14. The method of at least one of claims 8 to 13, **characterised in that** at least one auxiliary layer (9) is provided on the top layer (4) prior to the weakening step.

15. The method of claim 14, **characterised in that** providing the auxiliary layer (9) comprises depositing a silicon dioxide layer.

16. The method of at least one of claims 8 to 15, **characterised in that** fabricating the base structure comprises fabricating a silicon-on-insulator structure (10, 10a).

17. The method of at least one of claims 8 to 16, **characterised in that** the method further comprises providing a second single-crystalline epitaxial layer (8) on the top layer (4), wherein a lattice constant of the deposited second layer (8) is different from a lattice constant of the top layer (4), resulting in a heteroepitaxial structure (7).

18. The method of claim 17, **characterised in that** the second single-crystalline epitaxial layer (8) is provided on the top layer (4) after the weakening of the region (5) and/or the region (13).

19. The method of at least one of the claims 17 or 18 **characterised in that** the method further comprises an annealing step of the heteroepitaxial structure (7).
